# EUROPEAN PATENT APPLICATION

(11) **EP 4 836 624 A2**
(43) Date of publication of application: **04.11.2026**
(21) Application number: 26168899.8
(22) Date of filing: 30.03.2026
(51) Int. Cl.: H10B 12/00

(54) **SEMICONDUCTOR DEVICES INCLUDING CONTACT PLUG STRUCTURE**

(30) Priority: 29.04.2025 KR 20250056704
(71) Applicant: Samsung Electronics Co., Ltd., Suwon-si, Gyeonggi-do 16677 (KR)
(72) Inventor: CHA, Youngjun, 16677 Suwon-si, Gyeonggi-do (KR); YOON, Chansic, 16677 Suwon-si, Gyeonggi-do (KR); KIM, Youngsin, 16677 Suwon-si, Gyeonggi-do (KR); CHO, Yujin, 16677 Suwon-si, Gyeonggi-do (KR)
(74) Representative: Kuhnen & Wacker Patent- und Rechtsanwaltsbüro PartG mbB

(57) **Abstract**

A semiconductor device includes an active pattern on a substrate, a gate structure in an upper portion of the active pattern, a bit line structure on a central portion of the active pattern, a contact plug structure on each of opposite end portions of the active pattern, the contact plug structure including a first lower contact plug, a second lower contact plug disposed on the first lower contact plug and having a width greater than a width of the first lower contact plug in a vertical cross-section, an ohmic contact pattern on the second lower contact plug, and an upper contact plug on the ohmic contact pattern, spacers on opposite sidewalls, respectively, of the first lower contact plug, and a capacitor on the contact plug structure. Each of the spacers has a lowermost surface lower than or substantially coplanar with a lowermost surface of the first lower contact plug.

## Description

### CROSS-REFERENCE TO RELATED APPLICATION

This application claims priority to Korean Patent Application No. 10-2025-0056704 filed on April 29, 2025 in the Korean Intellectual Property Office, the disclosure of which is hereby incorporated by reference in its entirety.

### TECHNICAL FIELD

Example embodiments of the present disclosure relate to a semiconductor device.

### BACKGROUND

A DRDM device includes an active pattern on a substrate, gate structures extending in a first direction, bit line structures extending in a second direction, and capacitors disposed in each of the first and second directions, and contact plug structures are disposed between end portions of the active pattern and the capacitors. Thus, if the contact plug structure has a low resistance, electric characteristics of the DRAM device may be enhanced.

### SUMMARY

Example embodiments provide a semiconductor device having improved characteristics.

According to example embodiments of the inventive concepts, there is provided a semiconductor device. The semiconductor device may include an active pattern on a substrate, a gate structure in an upper portion of the active pattern, a bit line structure on a central portion of the active pattern, a contact plug structure on each of opposite end portions of the active pattern, the contact plug structure including a first lower contact plug, a second lower contact plug disposed on the first lower contact plug and having a width greater than a width of the first lower contact plug in a vertical cross-section of the semiconductor device, an ohmic contact pattern on the second lower contact plug, and an upper contact plug on the ohmic contact pattern, spacers on opposite sidewalls, respectively, of the first lower contact plug, and a capacitor on the contact plug structure. Each of the spacers may have a lowermost surface lower than or substantially coplanar with a lowermost surface of the first lower contact plug.

According to example embodiments of the inventive concepts, there is provided a semiconductor device. The semiconductor device may include an active pattern on a substrate, a gate structure in an upper portion of the active pattern, a bit line structure on a central portion of the active pattern, a first lower contact plug on each of opposite end portions of the active pattern, spacers on opposite sidewalls, respectively, of the first lower contact plug, a second lower contact plug contacting an upper surface of the first lower contact plug and upper surfaces of the spacers, an ohmic contact pattern on the second lower contact plug, an upper contact plug on the ohmic contact pattern, and a capacitor on the upper contact plug. Each of the spacers may not overlap the first lower contact plug in a vertical direction substantially perpendicular to an upper surface of the substrate.

According to example embodiments of the inventive concepts, there is provided a semiconductor device. The semiconductor device may include an active pattern on a substrate, a gate structure in an upper portion of the active pattern, a bit line structure disposed on a central portion of the active pattern and extending in a first direction substantially parallel to an upper surface of the substrate, a first lower contact plug on each of opposite end portions of the active pattern, a spacer on a sidewall in the first direction of the first lower contact plug, a second lower contact plug on the first lower contact plug and the spacer, an ohmic contact pattern on the second lower contact plug, an upper contact plug on the ohmic contact pattern, a fence pattern disposed on the substrate and contacting a sidewall in the first direction of the spacer, capping patterns on an upper surface of the bit line structure and an upper surface of the fence pattern, respectively, and a capacitor on the upper contact plug.

The contact plug structure included in the semiconductor device in accordance with example embodiments may have a reduced resistance, and thus the semiconductor device may have enhanced electric characteristics.

### BRIEF DESCRIPTION OF THE DRAWINGS

FIG. 1A is a plan view illustrating a semiconductor device in accordance with example embodiments, and FIG. 1B is a planar layout view of some elements of the semiconductor device.
FIG. 2 is a cross-sectional view taken along line A-A' of FIGS. 1A and 1B.
FIG. 3 is a cross-sectional view taken along line B-B' of FIGS. 1A and 1B.
FIGS. 4 to 41 are plan views and cross-sectional views illustrating a method of manufacturing a semiconductor device in accordance with example embodiments, in which FIGS. 4, 7, 12, 15, 21, 36 and 39 are the plan views, FIGS. 5, 8, 10, 13, 14, 16, 19, 22, 24, 26, 28, 30, 32, 34, 37 and 40 are cross-sectional views taken along lines A-A' of corresponding plan views, respectively, and FIGS. 6, 9, 11, 17, 18, 20, 23, 25, 27, 29, 31, 33, 35, 38 and 41 are cross-sectional views taken along lines B-B' of corresponding plan views.
FIG. 42 is a cross-sectional view illustrating a semiconductor device in accordance with example embodiments.

### DETAILED DESCRIPTION

The above and other aspects and features of a semiconductor device and a method of forming the same in accordance with example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

Hereinafter, two directions among horizontal directions that are substantially parallel to an upper surface of a substrate, which may be substantially perpendicular to each other, may be referred to as first and second directions D1 and D2, and a direction among the horizontal direction, which may have an acute angle with respect to the first and second directions D1 and D2, may be referred to as a third direction D3. A direction substantially perpendicular to the upper surface of the substrate may be referred to as a vertical direction. The expression "substantially perpendicular" or the like may mean that the terms being described are perpendicular to each other, or the terms being described are almost perpendicular to each other but with some variation due to an unperfect process or a margin, an error, or a tolerance in manufacturing or measurement. Such a margin, an error, or a tolerance may occur in manufacturing or measurement, recognized by those of skill in the art. In one or more aspects, it may include an industry-accepted tolerance or margin, indicating that an angle between the terms being described may be 90±1 degree, 90±5 degree, or 90±10 degree. The expression "substantially parallel" or the like may mean that the terms being described are parallel to each other, or the terms being described are almost parallel to each other but with some variation due to an unperfect process or a margin, an error, or a tolerance in manufacturing or measurement. Such a margin, an error, or a tolerance may occur in manufacturing or measurement, recognized by those of skill in the art. In one or more aspects, it may include an industry-accepted tolerance or margin, indicating that an angle between the terms being described may be ±1 degree, ±5 degree, or ±10 degree. Each of the first to third directions D1, D2 and D3 may indicate not only a direction shown in the drawings but also a direction opposite thereto.

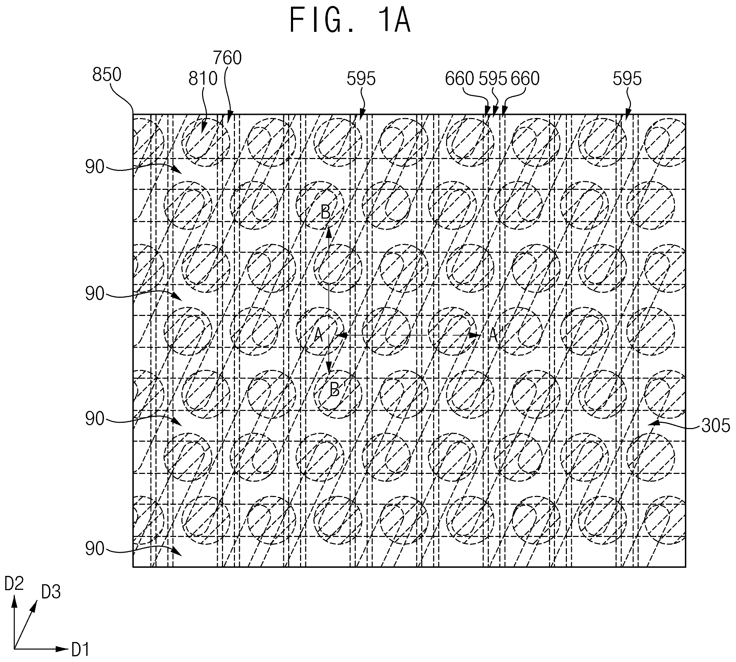

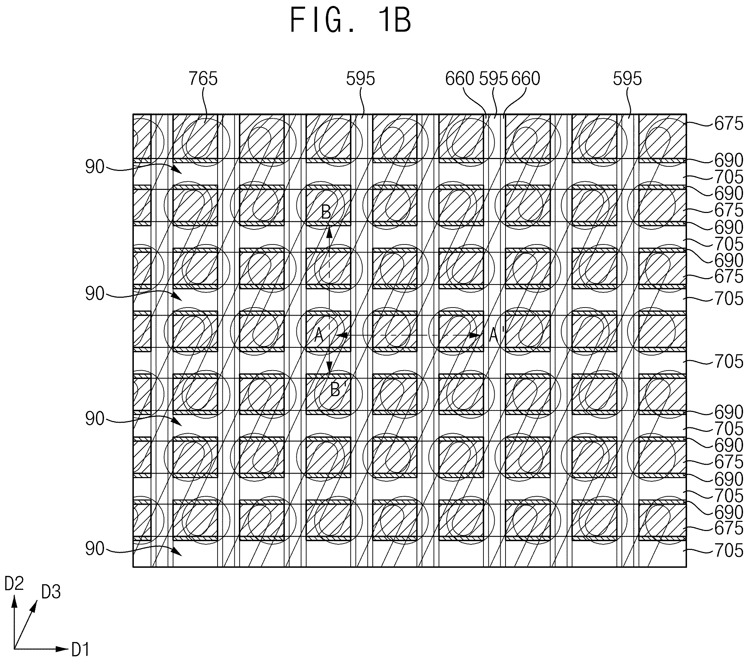

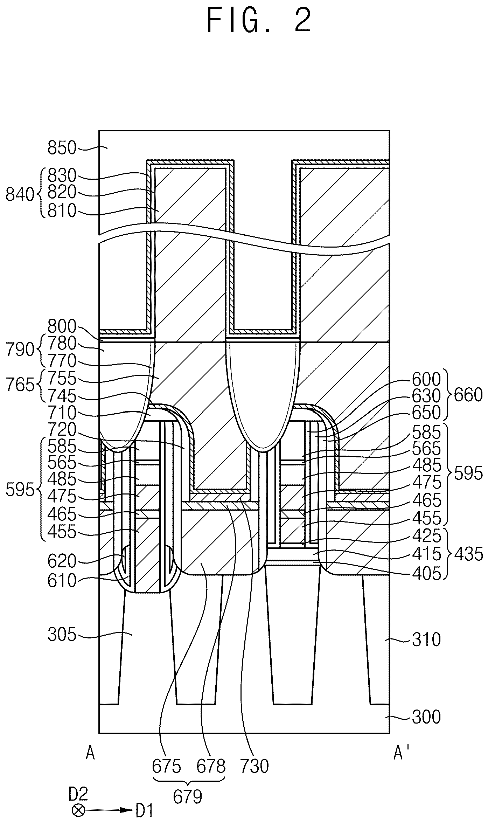

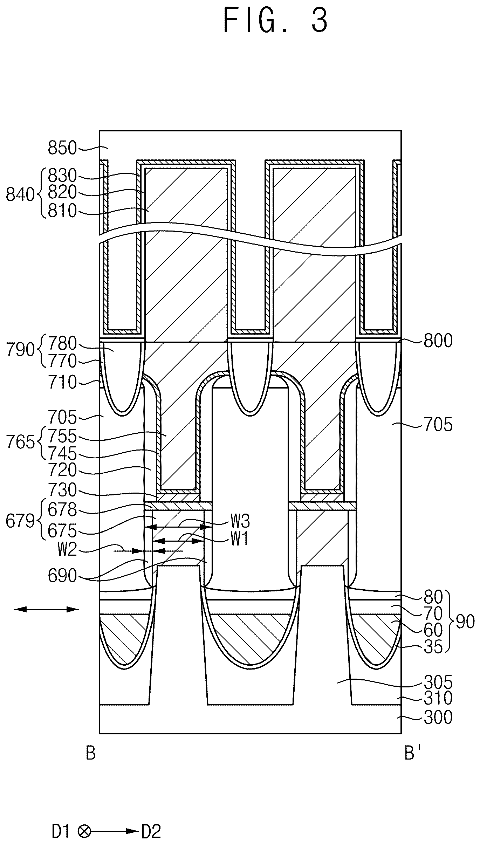

FIG. 1A is a plan view illustrating a semiconductor device in accordance with example embodiments, FIG. 1B is a planar layout view of some elements of the semiconductor device, FIG. 2 is a cross-sectional view taken along line A-A' of FIGS. 1A and 1B, and FIG. 3 is a cross-sectional view taken along line B-B' of FIGS. 1A and 1B.

Referring to FIGS. 1A, 1B, 2 and 3, the semiconductor device may include an active pattern 305, a gate structure 90, a bit line structure 595, a contact plug structure and a capacitor 840.

Additionally, the semiconductor device may further include an isolation pattern 310, a spacer structure 660, a fourth spacer 690, a fence pattern 705, a second capping pattern 710, a passivation pattern 720, first and second insulation pattern structures 435 and 790, fourth and fifth insulation patterns 610 and 620, a second etch stop layer 800 and a plate electrode 850.

The substrate 300 may include a semiconductor material, e.g., silicon, germanium, silicon-germanium, etc., or a III-V group compound semiconductor, e.g., GaP, GaAs, GaSb, etc. In example embodiments, the substrate 300 may be a silicon-on-insulator (SOI) substrate or a germanium-on-insulator (GOI) substrate.

The active pattern 305 may be disposed on a substrate 300 and may extend in the third direction D3. In example embodiments, a plurality of active patterns 305 may be spaced apart from each other in each of the first and second directions D1 and D2. A sidewall of the active pattern 305 may be covered by the isolation pattern 310. The active pattern 305 may include substantially the same material as the substrate 300, and a source/drain region including n-type or p-type impurities may be disposed at an upper portion of the active pattern 305.

The isolation pattern 310 may include an oxide, e.g., silicon oxide.

The gate structure 90 may be disposed in a second recess extending through the active pattern 305 and the isolation pattern 310 in the first direction D1. In example embodiments, the gate structure 90 may extend in the first direction D1, and a plurality of gate structures 90 may be spaced apart from each other in the second direction D2.

The gate structure 90 may include a gate insulation pattern 35 on an inner wall of the second recess, and a first conductive pattern 60, a second conductive pattern 70 and a gate mask 80 sequentially stacked on the gate insulation pattern 35 in the vertical direction, and the first and second conductive patterns 60 and 70 may collectively form a gate electrode. The gate insulation pattern 35 may contact a lower surface and a sidewall of the first conductive pattern 60, a sidewall of the second conductive pattern 70 and a sidewall of the gate mask 80.

The gate insulation pattern 35 may include, e.g., silicon oxide or a metal oxide, the first conductive pattern 60 may include a low resistance metal, e.g., molybdenum, tungsten, etc., the second conductive pattern 70 may include, e.g., polysilicon doped with n-type or p-type impurities, and the gate mask 80 may include an insulating nitride, e.g., silicon nitride, or an oxide, e.g., silicon oxide.

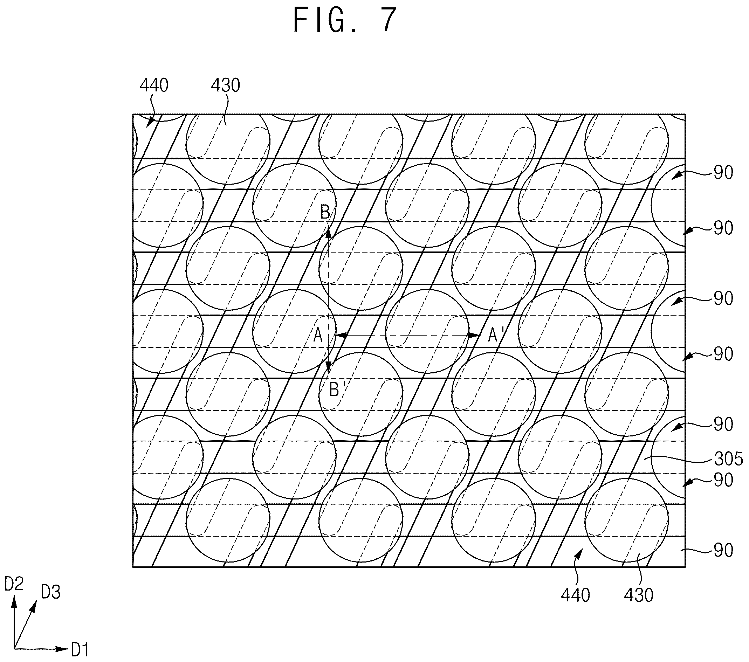

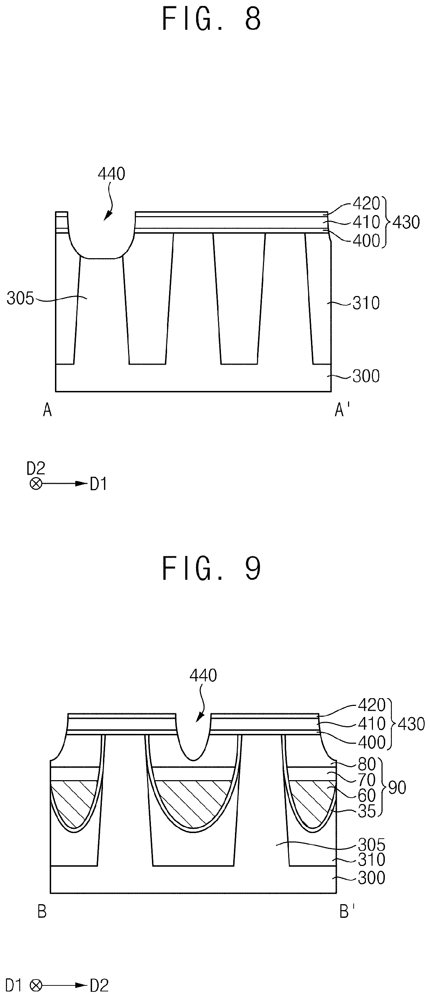

Referring to FIGS. 7 and 8 together with FIGS. 1A, 1B, 2 and 3, a first opening 440 extending through the insulation layer structure 430 to expose upper surfaces of the active pattern 305, the isolation pattern 310, the gate mask 80 and the gate insulation pattern 35 may be formed, and an upper surface of a central portion of the active pattern 305 in the third direction D3 may be exposed by the first opening 440.

In example embodiments, an area of a bottom of the first opening 440 may be greater than an area of the upper surface of the active pattern 305 exposed by the first opening 440. Thus, the first opening 440 may also expose the upper surface of the isolation pattern 310 adjacent to the active pattern 305. Additionally, the first opening 440 may extend through an upper portion of the active pattern 305 and an upper portion of the isolation pattern 310 adjacent thereto, and thus a bottom of the first opening 440 may be lower than an upper surface of a portion of the active pattern 305 on which the first opening 440 is not formed, that is, an upper surface of an end portion in the third direction D3 of the active pattern 305.

The bit line structure 595 may include a third conductive pattern 455, a first barrier pattern 465, a fourth conductive pattern 475, a first mask 485, a first etch stop pattern 565 and a first capping pattern 585 sequentially stacked in the vertical direction on the first opening 440 or on the first insulation pattern structure 435. The third conductive pattern 455, the first barrier pattern 465 and the fourth conductive pattern 475 may collectively form a conductive structure, and the first mask 485, the first etch stop pattern 565 and the first capping pattern 585 may collectively form an insulation structure.

The third conductive pattern 455 may include, e.g., doped polysilicon, the first barrier pattern 465 may include a metal nitride, e.g., titanium nitride, or a metal silicon nitride, e.g., titanium silicon nitride, the fourth conductive pattern 475 may include a metal, e.g., tungsten, and each of the first mask 485, the first etch stop pattern 565 and the first capping pattern 585 may include an insulating nitride, e.g., silicon nitride.

In example embodiments, the bit line structure 595 may extend in the second direction D2 on the substrate 300, and a plurality of bit line structures 595 may be spaced apart from each other in the first direction D1.

The fourth and fifth insulation patterns 610 and 620 may be disposed in the first opening 440, and may contact a lower sidewall of the bit line structure 595. The fourth insulation pattern 610 may include an oxide, e.g., silicon oxide, and the fifth insulation pattern 620 may include an insulating nitride, e.g., silicon nitride.

The first insulation pattern structure 435 may be disposed under the bit line structure 595 on the active pattern 305 and the isolation pattern 310, and may include first, second and third insulation patterns 405, 415 and 425 sequentially stacked in the vertical direction. The first and third insulation patterns 405 and 425 may include an oxide, e.g., silicon oxide, and the second insulation pattern 415 may include an insulating nitride, e.g., silicon nitride.

The contact plug structure may include a lower contact plug structure 679, an ohmic contact pattern 730 and an upper contact plug 765 sequentially stacked on the active pattern 305 and the isolation pattern 310 in the vertical direction.

The lower contact plug structure 679 may contact the upper surface of each of opposite end portions in the third direction D3 of the active pattern 305. In example embodiments, a plurality of lower contact plug structures 679 may be spaced apart from each other in the second direction D2 between neighboring ones of the bit line structures 595 in the first direction D1, and the fence pattern 705 may be disposed between neighboring ones of the lower contact plug structures 679 in the second direction D2.

The lower contact plug structure 679 may include a first lower contact plug 675 and a second lower contact plug 678 sequentially stacked in the vertical direction. In example embodiments, the fourth spacer 690 may be disposed on each of opposite sidewalls in the second direction D2 of the first lower contact plug 675, and thus may not overlap the first lower contact plug 675 in the vertical direction.

The second lower contact plug 678 may contact an upper surface of the first lower contact plug 675 and upper surfaces of the fourth spacers 690 on the sidewalls of the first lower contact plug 675. In example embodiments, a lowermost surface of the fourth spacer 690 may be lower than or substantially coplanar with a lowermost surface of the first lower contact plug 675. The expression "substantially coplanar" or the like may mean that the terms being described are coplanar with each other, or the terms being described are almost on a same plane but with some variation due to an unperfect process or a margin, an error, or a tolerance in manufacturing or measurement. Such a margin, an error, or a tolerance may occur in manufacturing or measurement, recognized by those of skill in the art. In one or more aspects, it may indicate an industry-accepted tolerance or margin, such as ± 1%, ± 5% , or ± 10%, between heights of the terms being described with respect to a reference plane, for example, a lower surface of the substrate 300.

The first lower contact plug 675 may have a first width W1 in the second direction D2, each of the fourth spacers 690 may have a second width W2 in the second direction D2, and the second lower contact plug 678 may have a third width W3 in the second direction D2. In an example embodiment, the first width W1 may be in a range of about 13nm to about 17nm, the second width W2 may be in a range of about 1.5nm to about 2.5nm, and the third width W3 may be in a range of about 14.5nm to about 17.5nm.

In example embodiments, the third width W3 may be substantially equal to a sum of the first and second widths W1 and W2. The expression "substantially equal to" or the like may mean that the values being described are equal to each other, or the values being described are almost equal to each other but with some variation due to an unperfect process or a margin, an error, or a tolerance in manufacturing or measurement. Such a margin, an error, or a tolerance may occur in manufacturing or measurement, recognized by those of skill in the art. In one or more aspects, it may indicate an industry-accepted tolerance or margin, such as ± 1%, ± 5% , or ± 10%, between the values being described. Thus, the second lower contact plug 678 may have a width in the second direction D2 greater than that of the first lower contact plug 675, and the second lower contact plug 678 may have a planar area greater than that of the first lower contact plug 675.

A width in the first direction D1 of the second lower contact plug 678 may be substantially equal to a width in the first direction D1 of the first lower contact plug 675.

Each of the first and second lower contact plugs 675 and 678 may include a polycrystalline semiconductor material doped with impurities, e.g., polysilicon doped with impurities. In an example embodiment, the first and second lower contact plugs 675 and 678 may include the same material so as not to be distinguished from each other. Alternatively, the first and second lower contact plugs 675 and 678 may include different materials or may have different impurity concentrations so as to be distinguished from each other.

In example embodiments, an upper surface of the fourth spacer 690 may be substantially flat, and may be substantially coplanar with an upper surface of the first lower contact plug 675. In example embodiments, a lower surface of the fourth spacer 690 may be rounded, and a width in the second direction D2 of a lower end of the fourth spacer 690 may gradually decrease downwardly.

The fourth spacer 690 may include an oxide, e.g., silicon oxide.

In example embodiments, a plurality of fence patterns 705 may be spaced apart from each other in the second direction D2 between neighboring ones of the bit line structures 595 in the first direction D1. The fence patterns 705 and the lower contact plug structures 679 may be alternately and repeatedly disposed in the second direction D2, and the fourth spacer 690 may be interposed between and contact sidewalls of the fence pattern 705 and the first lower contact plug 675.

In example embodiments, an upper surface of the fence pattern 705 may be higher than an upper surface of the lower contact plug structure 679, and may be substantially coplanar with an uppermost surface of the bit line structure 595. The fence pattern 705 may include an insulating nitride, e.g., silicon nitride.

The spacer structure 660 may cover a sidewall in the first direction D1 of the bit line structure 595 and a sidewall of the third insulation pattern 425, and may include first, second and third spacers 600, 630 and 650 sequentially stacked in the first direction D1. Each of the second and third spacers 630 and 650 may contact upper surfaces of the fourth and fifth insulation patterns 610 and 620, and the third spacer 650 may contact a sidewall of the first insulation pattern structure 435.

The spacer structure 660 may also contact a sidewall in the first direction D1 of the lower contact plug structure 679.

Each of the first and third spacers 600 and 650 may include an insulating nitride, e.g., silicon nitride, and the second spacer 630 may include an oxide, e.g., silicon oxide.

The second capping pattern 710 may be disposed on upper surfaces of the bit line structure 595 and the fence pattern 705. An upper surface of the second capping pattern 710 may not be flat but may be curved, e.g., rounded. In an example embodiment, the second capping patterns 710 on the upper surfaces of the bit line structure 595 and the fence pattern 705, respectively, may have substantially the same thickness in the vertical direction, however, the inventive concept is not limited thereto.

The second capping pattern 710 may include an insulating nitride, e.g., silicon nitride. In an example embodiment, the second capping pattern 710 may include a material substantially the same as that of the first capping pattern 585, the fence pattern 705 and the first and third spacers 600 and 650, and may be merged thereto. Alternatively, the second capping pattern 710 may include a material different from a material of at least one of the first capping pattern 585, the fence pattern 705 and the first and third spacers 600 and 650, and may be distinguished therefrom.

The passivation pattern 720 may cover an upper portion of an outer sidewall of the spacer structure 660 in the first direction D1 of the bit line structure 595 and an upper portion of a sidewall in the second direction D2 of the fence pattern 705, and may contact an upper surface of an edge portion of the second lower contact plug 678, that is, upper surfaces of each of end portions in the first direction D1 and each of end portions in the second direction D2 of the second lower contact plug 678. Thus, a lower surface of the passivation pattern 720 may be substantially coplanar with an upper surface of the second lower contact plug 678.

In example embodiments, at least a portion of the passivation pattern 720 may overlap the fourth spacer 690 in the vertical direction.

The passivation pattern 720 may include an insulating nitride, e.g., silicon nitride.

The ohmic contact pattern 730 may contact upper surfaces of other portions except for the edge portion of the second lower contact plug 678, and may also contact a sidewall of a lower portion of the passivation pattern 720. Thus, a planar area of the ohmic contact pattern 730 may be less than a planar area of the second lower contact plug 678.

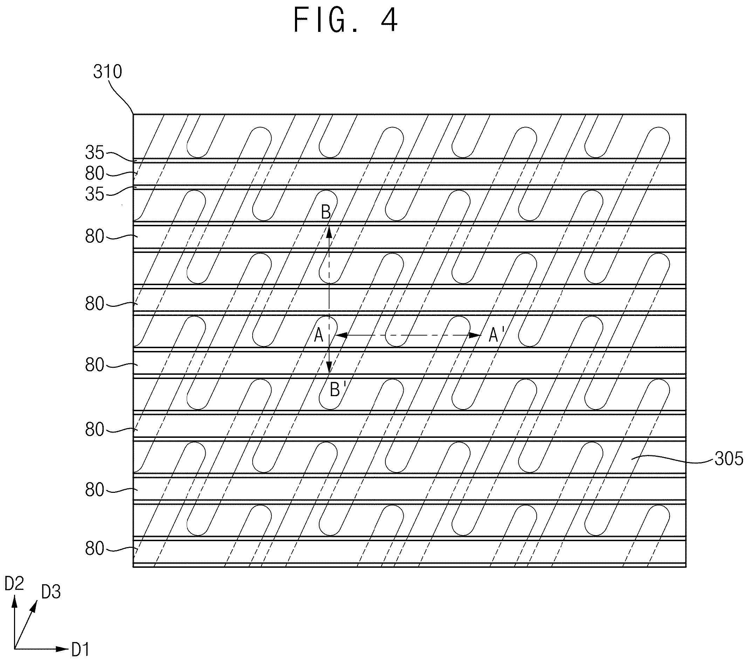

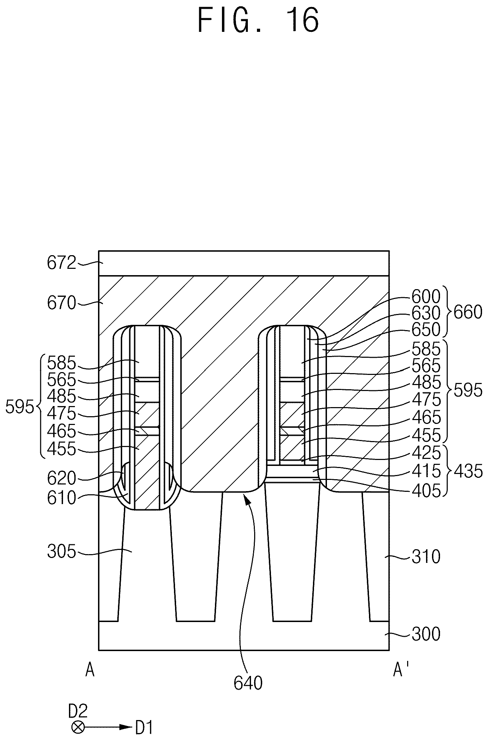

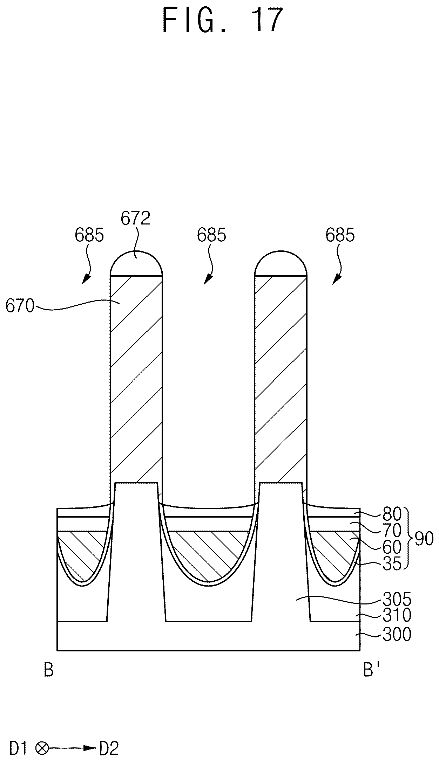

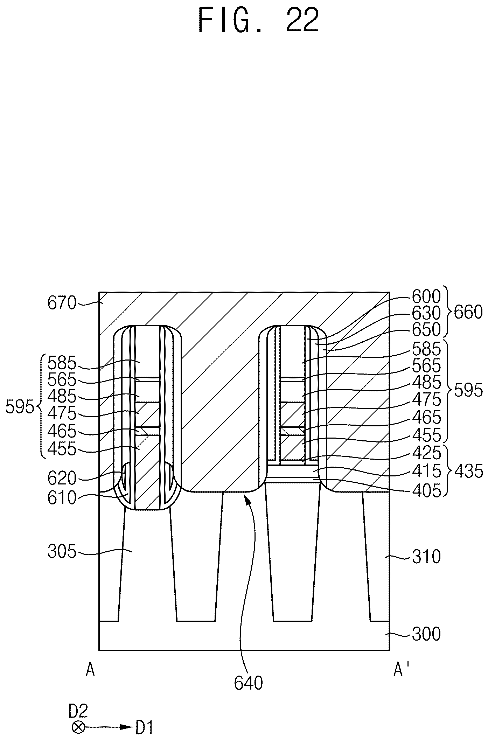

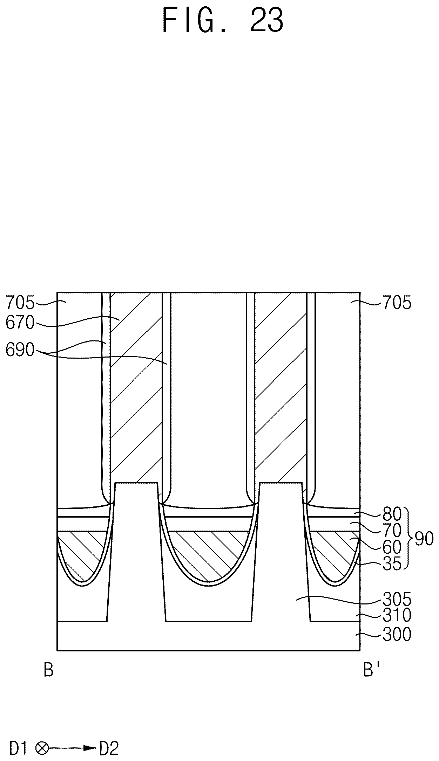

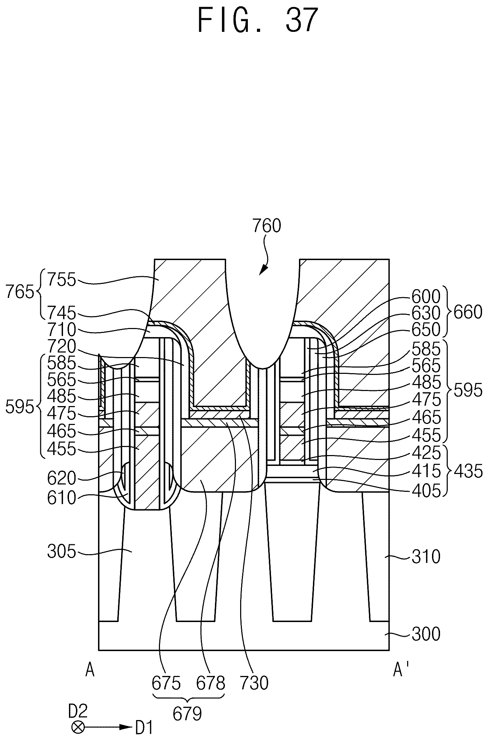

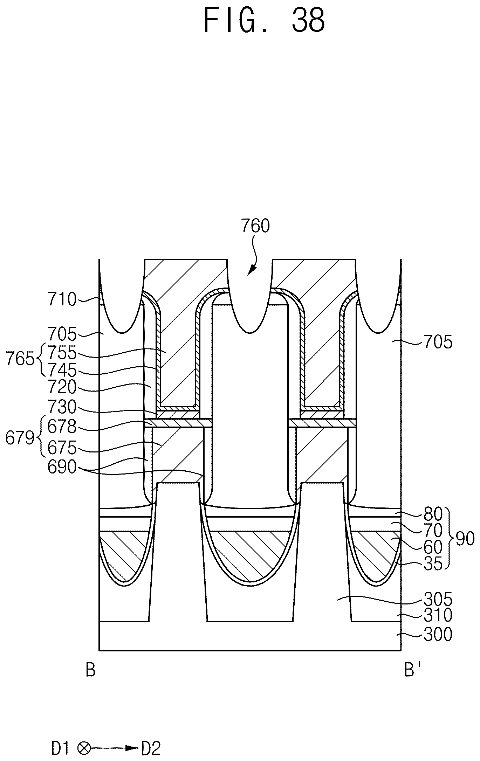

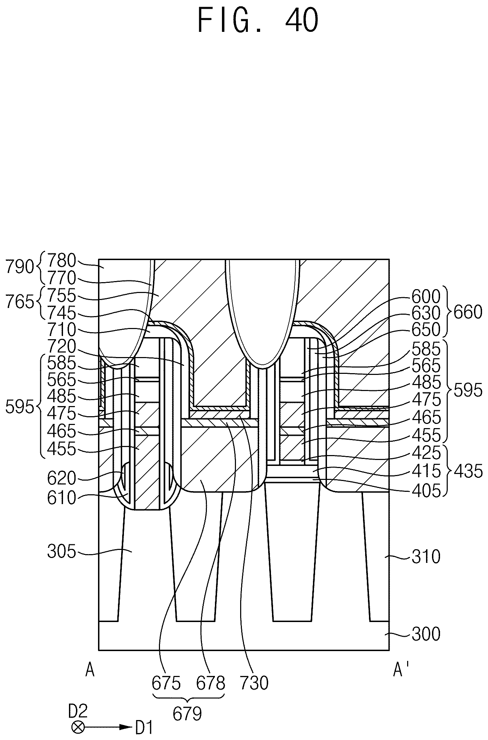

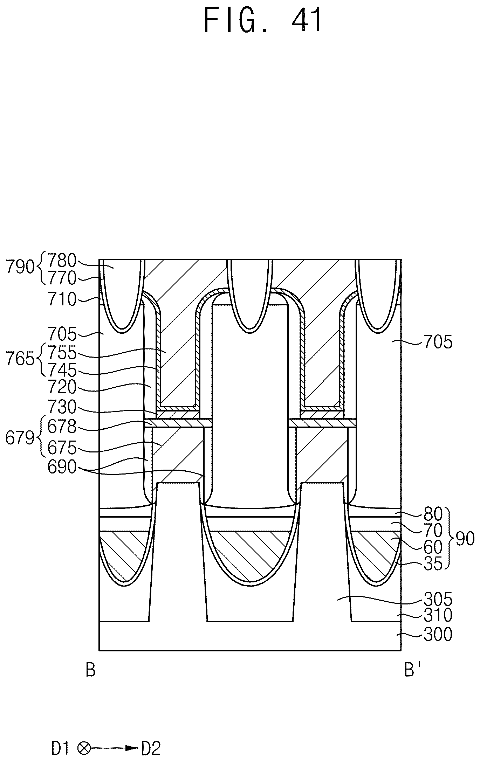

As illustrated below with reference to FIGS. 4 to 41, the ohmic contact pattern 730 may be formed to sufficiently contact an upper surface of the second lower contact plug 678 having a planar area greater than that of the first lower contact plug 675, even though a distance between ones of the fence patterns 705 neighboring in the second direction D2 decreases, and thus the ohmic contact pattern 730 may sufficiently contact the lower contact plug structure 679 including the first and second lower contact plugs 675 and 678.

The ohmic contact pattern 730 may include a metal silicide, e.g., cobalt silicide, nickel silicide, titanium silicide, etc.

The upper contact plug 765 may include a second metal pattern 755 and a second barrier pattern 745 covering a lower surface of the second metal pattern 755. The second metal pattern 755 may include a metal, e.g., tungsten, and the second barrier pattern 745 may include a metal nitride, e.g., titanium nitride.

In example embodiments, a plurality of upper contact plugs 765 may be spaced apart from each other in each of the first and second directions D1 and D2, and may be arranged in a honeycomb pattern or a lattice pattern. Each of the upper contact plugs 765 may have a shape of, e.g., a circle, an ellipse, a polygon, etc.

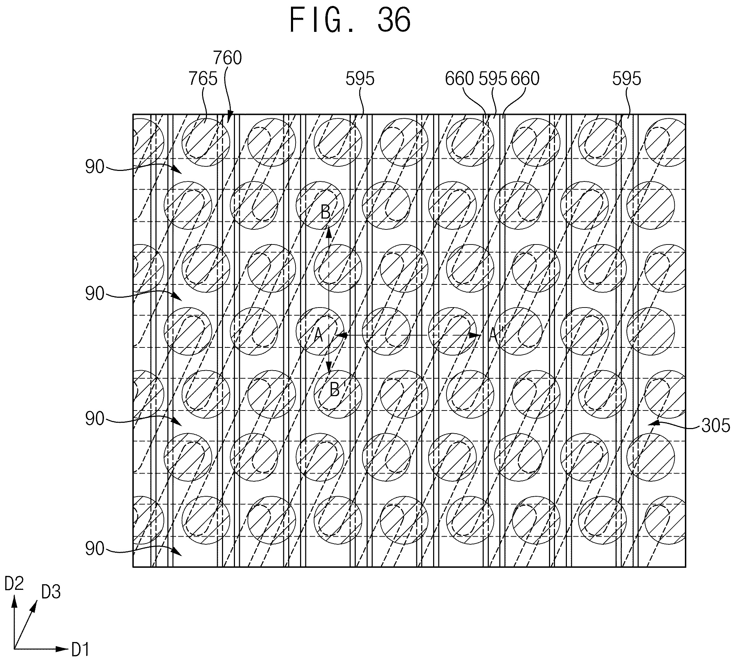

Referring to FIGS. 36 to 38 together with FIGS. 1A, 1B, 2 and 3, the second insulation pattern structure 790 may include a sixth insulation pattern 770 and a seventh insulation pattern 780. The sixth insulation pattern 770 may be disposed on an inner wall of a fourth opening 760 extending partially through the first and second capping patterns 585 and 710, the fence pattern 705, the spacer structure 660 and the passivation pattern 720 and surrounding the upper contact plug 765 in a plan view. The seventh insulation pattern 780 may be disposed on the sixth insulation pattern 770, and may fill a remaining portion of the fourth opening 760.

The sixth and seventh insulation patterns 770 and 780 may include an insulating nitride, e.g., silicon nitride, or an oxide, e.g., silicon oxide.

The second etch stop layer 800 may be disposed on the sixth and seventh insulation patterns 770 and 780 and the upper contact plug 765. The second etch stop layer 800 may include silicon nitride, e.g., silicon boronitride.

The capacitor 840 may include a lower electrode 810, a dielectric layer 820 and an upper electrode 830.

The lower electrode 810 may extend through the second etch stop layer 800 and may contact an upper surface of the upper contact plug 765. In example embodiments, a plurality of lower electrodes 810 may be spaced apart from each other in each of the first and second directions D1 and D2, and may be arranged in a honeycomb pattern or a lattice pattern in a plan view. Each of the lower electrodes 810 may have a shape of, e.g., a circle, an ellipse, a polygon, etc.

The dielectric layer 820 may cover a sidewall and an upper surface of the lower electrode 810 and an upper surface of the second etch stop layer 800, and the upper electrode 830 may be disposed on the dielectric layer 820.

Each of the lower and upper electrodes 810 and 830 may include, e.g., a metal, a metal nitride, a metal silicide, etc., and the dielectric layer 820 may include a metal oxide, e.g., hafnium oxide, zirconium oxide, etc.

The plate electrode 850 may be disposed on the upper electrode 830. The plate electrode 850 may include, e.g., silicon-germanium doped with p-type impurities.

In the semiconductor device, the lower contact plug structure 679 may include the first lower contact plug 675 having a relatively small planar area and the second lower contact plug 678 having a relatively large planar area, and the ohmic contact pattern 730 may be interposed between and contact the lower contact plug structure 679 and the upper contact plug 765.

As the ohmic contact pattern 730 may contact the upper surface of the second lower contact plug 678 having a planar area greater than that of the first lower contact plug 675, a contact resistance between the ohmic contact pattern 730 and the lower contact plug structure 679 may be reduced. Accordingly, the contact plug structure including the lower contact plug structure 679, the ohmic contact pattern 730 and the upper contact plug 765 may have a reduced resistance, and the semiconductor device including the contact plug structure may have enhanced electric characteristics.

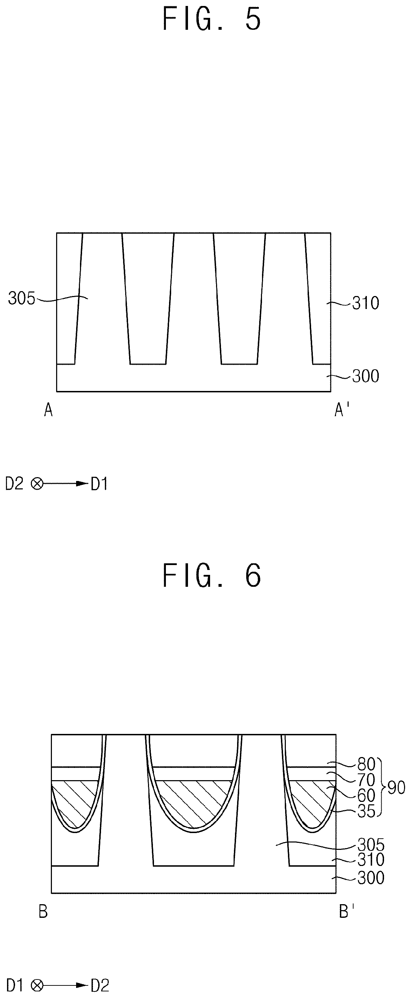

FIGS. 4 to 41 are plan views and cross-sectional views illustrating a method of manufacturing a semiconductor device in accordance with example embodiments. Particularly, FIGS. 4, 7, 12, 15, 21, 36 and 39 are the plan views, FIGS. 5, 8, 10, 13, 14, 16, 19, 22, 24, 26, 28, 30, 32, 34, 37 and 40 are cross-sectional views taken along lines A-A' of corresponding plan views, respectively, and FIGS. 6, 9, 11, 17, 18, 20, 23, 25, 27, 29, 31, 33, 35, 38 and 41 are cross-sectional views taken along lines B-B' of corresponding plan views, respectively.

Referring to FIGS. 4 to 6, an upper portion of a substrate 300 may be removed to form a first recess, and an isolation pattern 310 may be formed in the first recess.

As the first recess is formed on the substrate 300, an active pattern 305 may be defined on the substrate 300, and a sidewall of the active pattern 305 may be covered by the isolation pattern 310. For example, an ion implantation process may be performed onto an upper portion of the active pattern 305 so that a source/drain region may be formed in the upper portion of the active pattern 305.

The active pattern 305 and the isolation pattern 310 on the substrate 300 may be partially etched to form a second recess extending in the first direction D1, and a gate structure 90 may be formed in the second recess. The gate structure 90 may include a gate insulation pattern 35 on an inner wall of the second recess, and a first conductive pattern 60, a second conductive pattern 70 and a gate mask 80 sequentially stacked on the gate insulation pattern 35 in the vertical direction, and the first and second conductive patterns 60 and 70 may collectively form a gate electrode.

In example embodiments, the gate structure 90 may extend in the first direction D1, and a plurality of gate structures 90 may be formed to be spaced apart from each other in the second direction D2.

Referring to FIGS. 7 to 9, an insulation layer structure 430 may be formed on the active pattern 305, the isolation pattern 310 and the gate structure 90.

The insulation layer structure 430 may include first, second and third insulation layers 400, 410 and 420 sequentially stacked in the vertical direction.

The insulation layer structure 430 may be patterned, and the active pattern 305, the isolation pattern 310, the gate mask 80 and the gate insulation pattern 35 may be partially etched by an etching process using the patterned insulation layer structure 430 as an etching mask to form a first opening 440.

In example embodiments, the insulation layer structure 430 remaining after the etching process may have a shape of, e.g., a circle or an ellipse in a plan view, and a plurality of insulation layer structures 430 may be spaced apart from each other in each of the first and second directions D1 and D2. Each of the insulation layer structures 430 may overlap edge portions in the third direction D3 of neighboring active patterns 305, respectively.

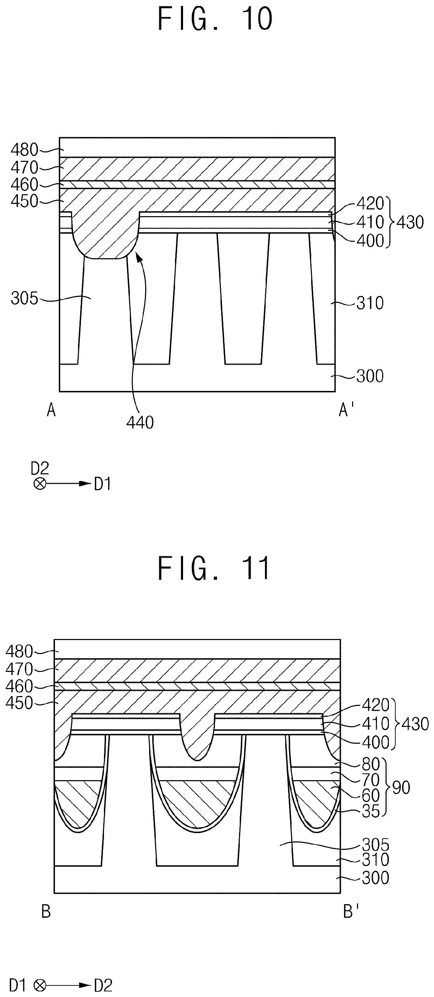

Referring to FIGS. 10 and 11, a third conductive layer 450 may be formed on the insulation layer structure 430 and the active pattern 305, the isolation pattern 310 and the gate structure 90 exposed by the first opening 440 to fill the first opening 440, and a first barrier layer 460, a fourth conductive layer 470 and a first mask layer 480 may be sequentially stacked on the third conductive layer 450.

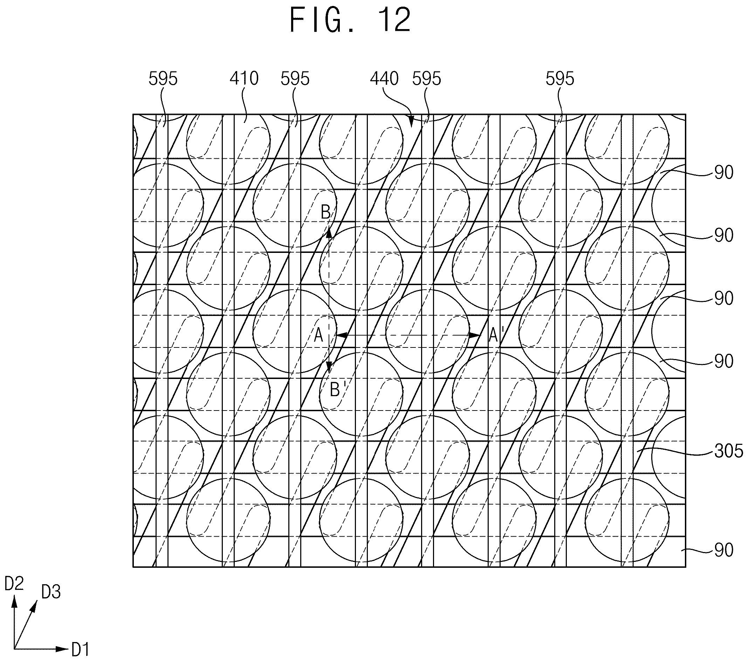

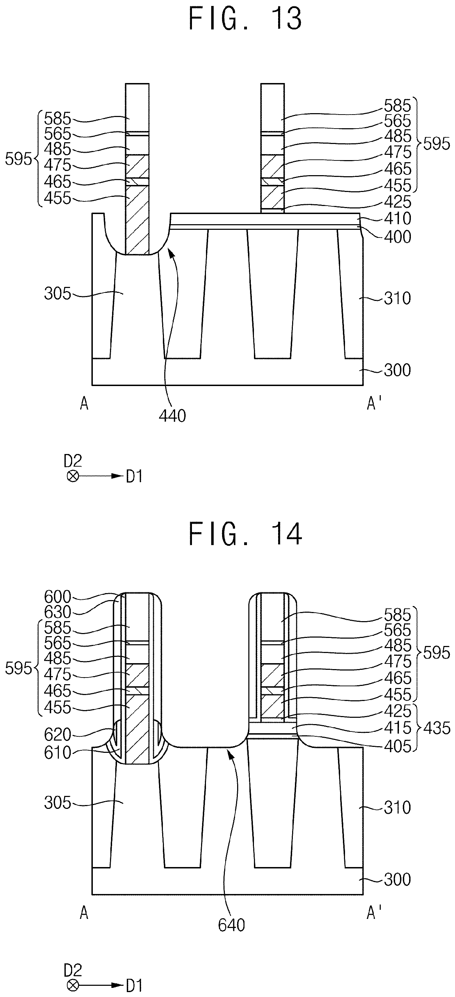

Referring to FIGS. 12 and 13, a first etch stop layer and a first capping layer may be sequentially stacked on the first mask layer 480, the first capping layer may be etched to form a first capping pattern 585, and the first etch stop layer, the first mask layer 480, the fourth conductive layer 470, the first barrier layer 460 and the third conductive layer 450 may be sequentially etched using the first capping pattern 585 as an etching mask.

In example embodiments, the first capping pattern 585 may extend in the second direction D2, and a plurality of first capping patterns 585 may be spaced apart from each other in the first direction D1.

By the etching process, a third conductive pattern 455, a first barrier pattern 465, a fourth conductive pattern 475, a first mask 485, a first etch stop pattern 565 and the first capping pattern 585 may be sequentially stacked on the first opening 440, and a third insulation pattern 425, the third conductive pattern 455, the first barrier pattern 465, the fourth conductive pattern 475, the first mask 485, the first etch stop pattern 565 and the first capping pattern 585 may be sequentially stacked on the second insulation layer 410 of the insulation layer structure 430 at an outside of the first opening 440.

Hereinafter, the third conductive pattern 455, the first barrier pattern 465, the fourth conductive pattern 475, the first mask 485, the first etch stop pattern 565 and the first capping pattern 585 sequentially stacked may be referred to as a bit line structure 595. The third conductive pattern 455, the first barrier pattern 465 and the fourth conductive pattern 475 may collectively form a conductive structure, and the first mask 485, the first etch stop pattern 565 and the first capping pattern 585 may collectively form an insulation structure.

In example embodiments, the bit line structure 595 may extend in the second direction D2 on the substrate 300, and a plurality of bit line structures 595 may be spaced apart from each other in the first direction D1.

Referring to FIG. 14, a first spacer layer may be formed on the substrate 300 having the bit line structure 595 thereon, and fourth and fifth insulation layers may be sequentially formed on the first spacer layer.

The first spacer layer may also cover a sidewall of the third insulation pattern 425 under a portion of the bit line structure 595 on the second insulation layer 410, and the fifth insulation layer may fill a remaining portion of the first opening 440.

The fourth and fifth insulation layers may be etched by an etching process. In example embodiments, the etching process may be performed by a wet etching process using an etching solution, e.g., H₂PO₃, SC1, HF, etc., and portions of the fourth and fifth insulation layers at the outside of the first opening 440 may be removed. Thus, a portion of the first spacer layer at the outside of the first opening 440 may be exposed, and portions of the fourth and fifth insulation layers in the first opening 440 may form fourth and fifth insulation patterns 610 and 620, respectively.

A second spacer layer may be formed on the exposed portion of the first spacer layer and the fourth and fifth insulation patterns 610 and 620 in the first opening 440, and may be anisotropically etched to form a second spacer 630 on the exposed portion of the first spacer and the fourth and fifth insulation patterns 610 and 620 to cover a sidewall of the bit line structure 595.

A dry etching process may be performed using the first capping pattern 585 and the second spacer 630 as an etching mask to form a second opening 640 exposing an upper surface of the active pattern 305, and upper surfaces of the isolation pattern 310, the gate mask 80 and the gate insulation pattern 35 may also be exposed by the second opening 640.

By the dry etching process, a portion of the first spacer layer on the first capping pattern 585 and the second insulation layer 410 may be removed, and thus a first spacer 600 covering a sidewall of the bit line structure 595 may be formed. Additionally, by the dry etching process, the first and second insulation layers 400 and 410 may also be partially etched so that first and second insulation patterns 405 and 415 may remain under the bit line structure 595. The first to third insulation patterns 405, 415 and 425 sequentially stacked under the bit line structure 595 may collectively form a first insulation pattern structure 435.

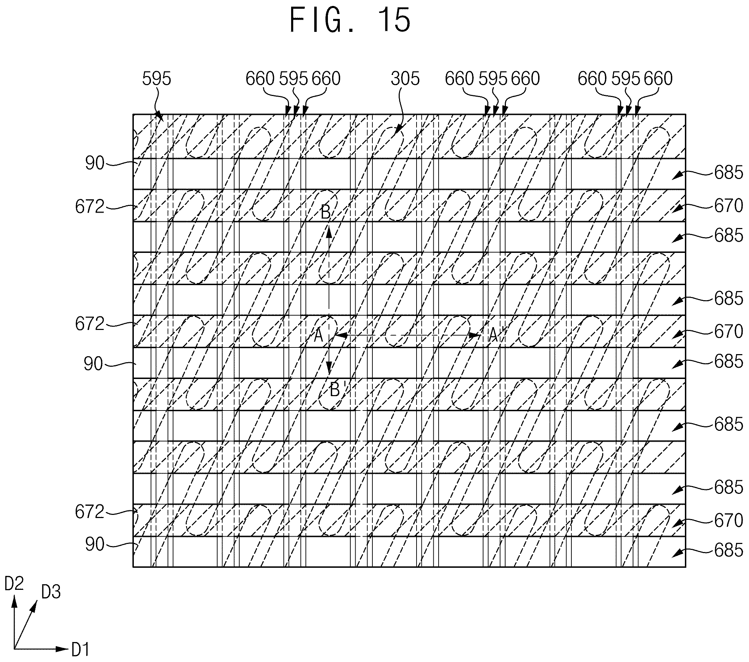

Referring to FIGS. 15 to 17, a third spacer layer may be formed on an upper surface of the first capping pattern 585, an upper surface and an outer sidewall of the second spacer 630, upper surfaces of the fourth and fifth insulation patterns 610 and 620, and the upper surfaces of the active pattern 305, the isolation pattern 310, the gate mask 80 and the gate insulation pattern 35 exposed by the second opening 640, and may be anisotropically etched to form a third spacer 650 on the sidewall of the bit line structure 595.

The first, second and third spacers 600, 630 and 650 sequentially stacked on the sidewall of the bit line structure 595 may collectively form a spacer structure 660.

A preliminary first lower contact plug layer may be formed on the substrate 300 to fill the second opening 640, a sacrificial mask 672 may be formed on the preliminary first lower contact plug layer, and the preliminary first lower contact plug layer may be patterned using the sacrificial mask 672 as an etching mask to form a first lower contact plug layer 670.

In example embodiments, the first lower contact plug layer 670 may extend in the first direction D1, and a plurality of first lower contact plug layers 670 may be spaced apart from each other in the second direction D2. A third opening 685 may be formed between ones of the first lower contact plug layers 670 neighboring in the second direction D2 to expose the upper surfaces of the active pattern 305, the isolation pattern 310 and the gate structure 90.

In example embodiments, the first lower contact plug layer 670 may be formed by a deposition process, e.g., a chemical vapor deposition (CVD) process, an atomic layer deposition (ALD) process, etc., and may include amorphous silicon doped with impurities.

A melting laser annealing (MLA) process may be performed on the first lower contact plug layer 670 so that the amorphous silicon doped with impurities included in the first lower contact plug layer 670 may be converted into polysilicon doped with impurities.

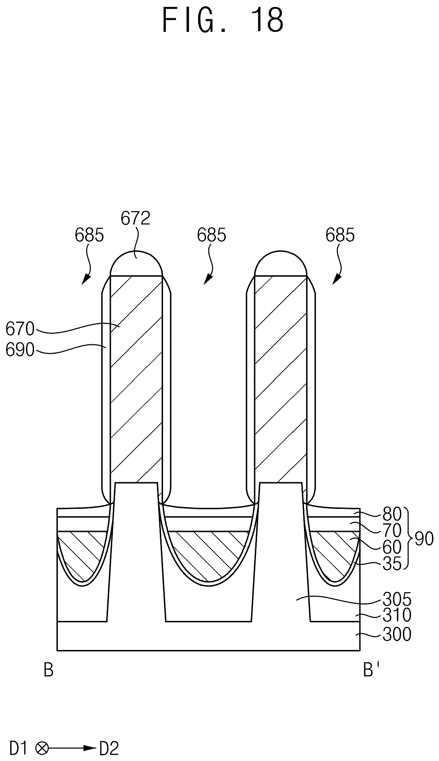

Referring to FIG. 18, a fourth spacer layer may be formed on a sidewall of the first lower contact plug layer 670, a sidewall and an upper surface of the sacrificial mask 672, and the upper surfaces of the active pattern 305, the isolation pattern 310, the gate mask 80 and the gate insulation pattern 35 exposed by the third opening 685, and an anisotropic etching process, e.g., a stripping process may be performed on the fourth spacer layer.

In example embodiments, the fourth spacer layer may be formed by an atomic layer deposition (ALD) process, and may include an oxide, e.g., silicon oxide.

By the anisotropic etching process, the fourth spacer layer may be transformed into a fourth spacer 690 on each of opposite sidewalls in the second direction D2 of the first lower contact plug layer 670.

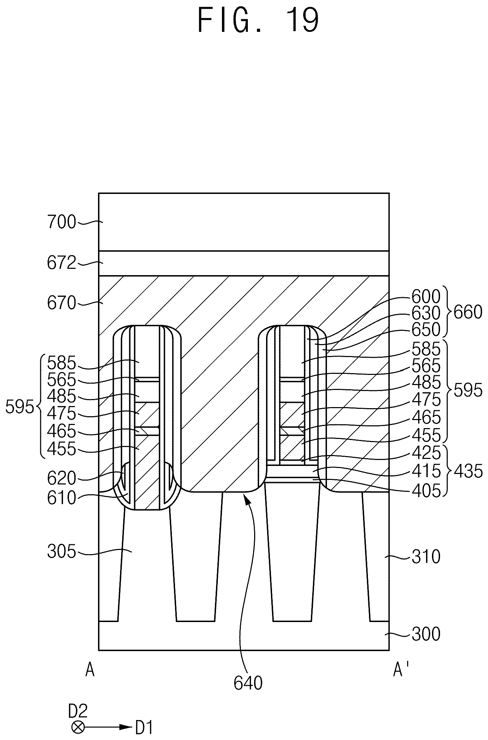

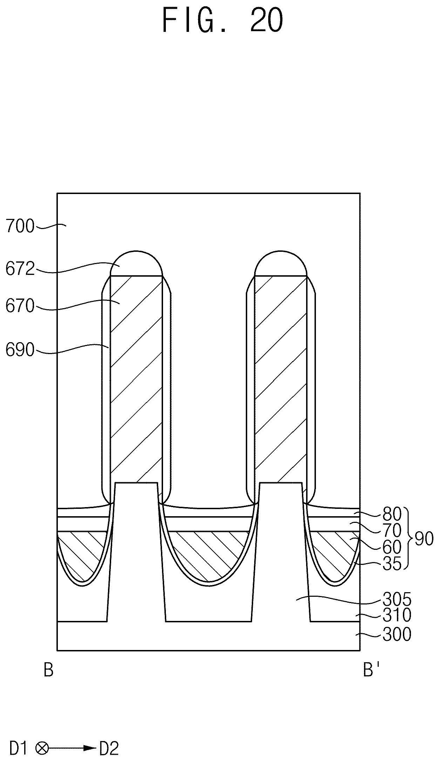

Referring to FIGS. 19 and 20, a fence layer 700 may be formed on the fourth spacer 690, the sacrificial mask 672, and the active pattern 305, the isolation pattern 310, the gate mask and the gate insulation pattern 35 exposed by the third opening 685 to fill the third opening 685.

A planarization process, e.g., a chemical mechanical polishing (CMP) process and/or an etch back process may be performed on an upper portion of the fence layer 700.

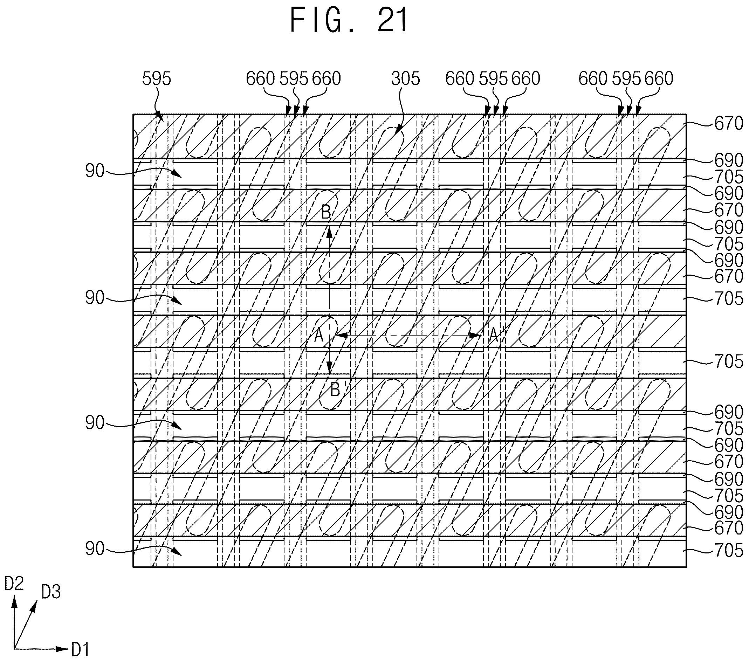

Referring to FIGS. 21 to 23, for example, an etch back process may be performed on the fence layer 700 until an upper surface of the first lower contact plug layer 670 is exposed, and thus the fence layer 700 may be divided into a plurality of fence patterns 705 each extending in the first direction D1 between the fourth spacers 690 on the respective sidewalls in the second direction D2 of the first lower contact plug layers 670.

For example, a wet etching process may be performed to remove the sacrificial mask 672, and thus the upper surface of the first lower contact plug layer 670 may be exposed.

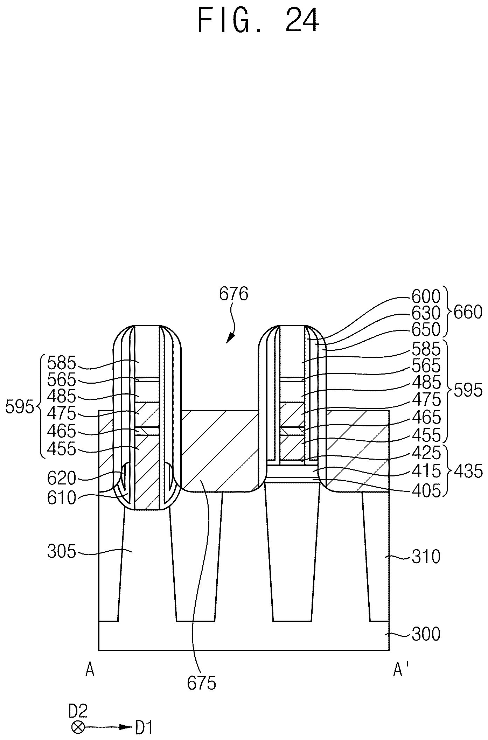

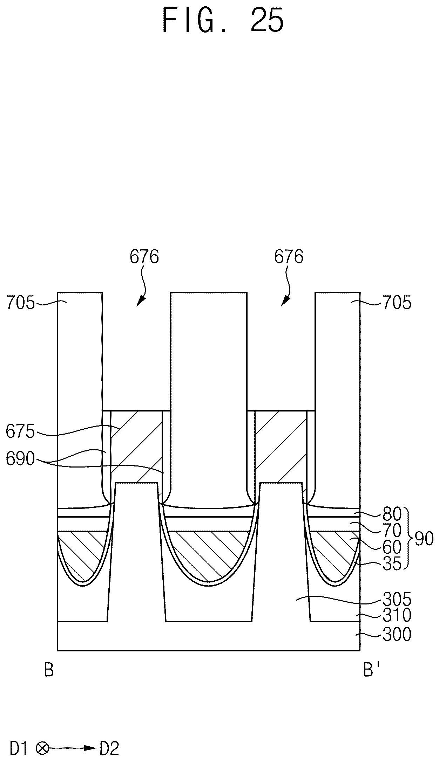

Referring to FIGS. 24 and 25, for example, an etch back process may be performed to remove an upper portion of the first lower contact plug layer 670, and thus the first lower contact plug layer 670 extending in the first direction D1 may be divided into a plurality of first lower contact plugs 675 spaced apart from each other in the first direction D1.

During the etch back process, an upper portion of the fourth spacer 690 on the sidewall in the second direction D2 of the first lower contact plug layer 670 may also be removed.

Thus, a third recess 676 exposing upper surfaces of the first lower contact plug 675 and the fourth spacer 690 may be formed between the spacer structures 660 on the respective sidewalls of the bit line structures 595 neighboring in the first direction D1 and between the fence patterns 705 neighboring in the second direction D2.

In example embodiments, the first lower contact plugs 675 may be formed to be spaced apart from each other in each of the first and second directions D1 and D2, and the upper surfaces of the first lower contact plug 675 and the fourth spacer 690 may be lower than an upper surface of the fourth conductive pattern 475 of the bit line structure 595 and higher than a lower surface thereof.

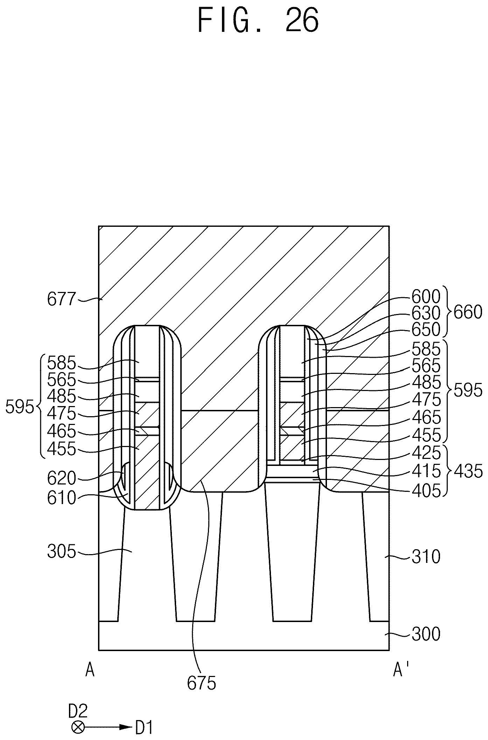

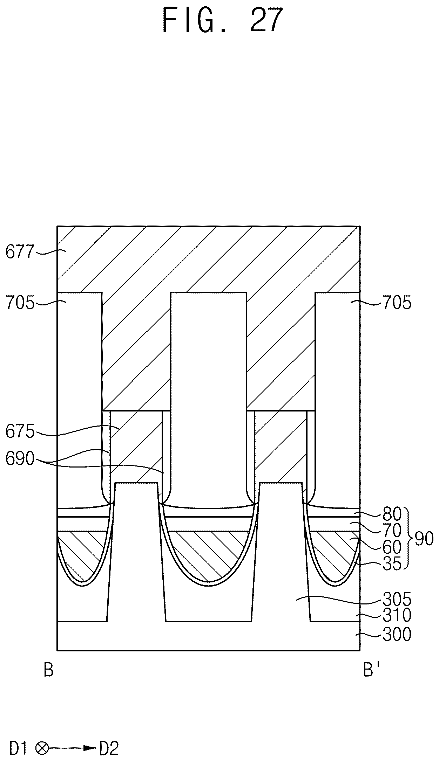

Referring to FIGS. 26 and 27, a second lower contact plug layer 677 including amorphous silicon doped with impurities may be formed on the bit line structure 595, the spacer structure 660, the fence pattern 705, the first lower contact plug 675 and the fourth spacer 690 by a deposition process to fill the third recess 676, and an MLA process may be performed on the second lower contact plug layer 677 so that the amorphous silicon doped with impurities included in the second lower contact plug layer 677 may be converted into polysilicon doped with impurities.

Alternatively, the second lower contact plug layer 677 may be formed by a selective epitaxial growth (SEG) process using the upper surface of the first lower contact plug 675 as a seed, and in this case, the second lower contact plug layer 677 may include polysilicon doped with impurities without performing an MLA process.

A planarization process, e.g., a CMP process and/or an etch back process may be further performed on an upper portion of the second lower contact plug layer 677.

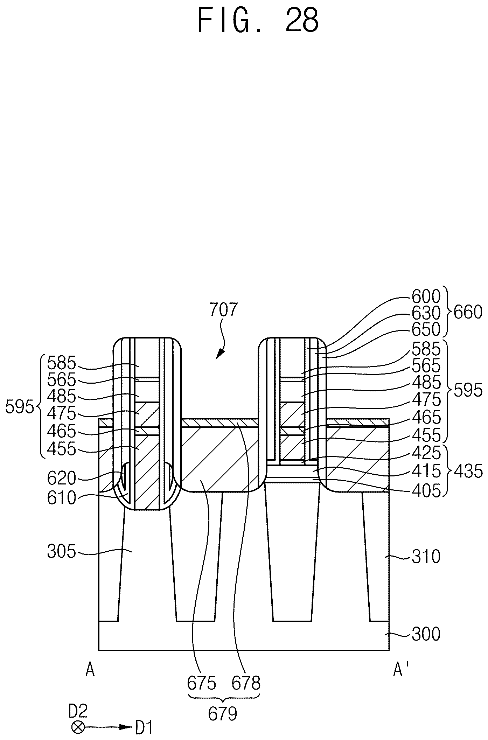

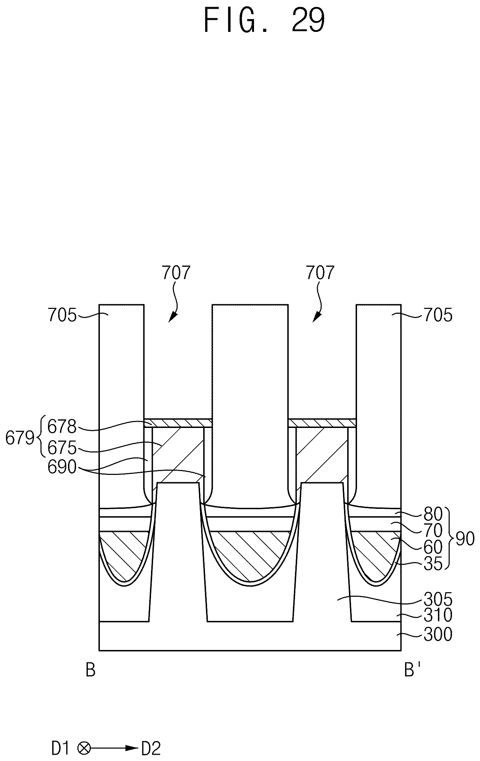

Referring to FIGS. 28 and 29, for example, an etch back process may be performed to remove an upper portion of the second lower contact plug layer 677, and thus a second lower contact plug 678 may be formed between the spacer structures 660 on the respective sidewalls of the bit line structures 595 neighboring in the first direction D1 and between the fence patterns 705 neighboring in the second direction D2.

In example embodiments, a plurality of second lower contact plugs 678 may be formed in each of the first and second directions D1 and D2, and each of the second lower contact plugs 678 may contact an upper surface of the first lower contact plug 675 and upper surfaces of the opposite sidewalls in the second direction D2 of the first lower contact plug 675. A planar area of the second lower contact plug 678 may be substantially equal to a sum of a planar area of the first lower contact plug 675 and planar areas of the fourth spacers 690, and thus the planar area of the second lower contact plug 678 may be greater than the planar area of the first lower contact plug 675.

The first and second lower contact plugs 675 and 678 sequentially stacked in the vertical direction may collectively form a lower contact plug structure 679.

By the etch back process on the second lower contact plug layer 677, upper portions of the bit line structure 595, the spacer structure 660 and the fence pattern 705 may also be partially removed so that upper surfaces thereof may be lowered, and a fourth recess 707 may be formed to expose an upper surface of the lower contact plug structure 679.

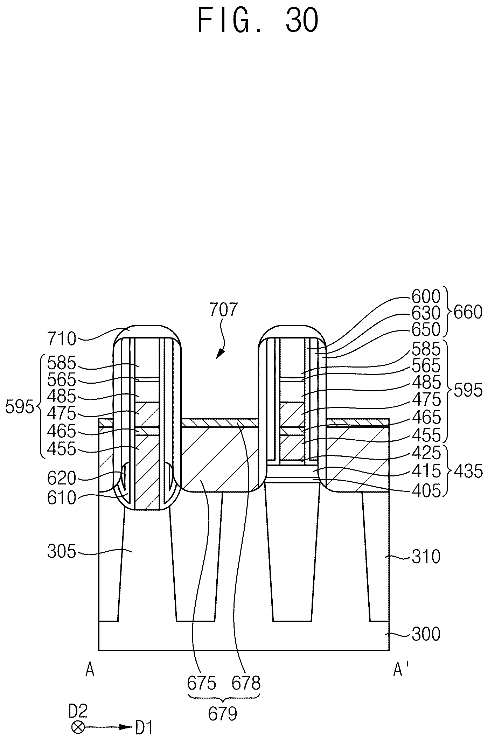

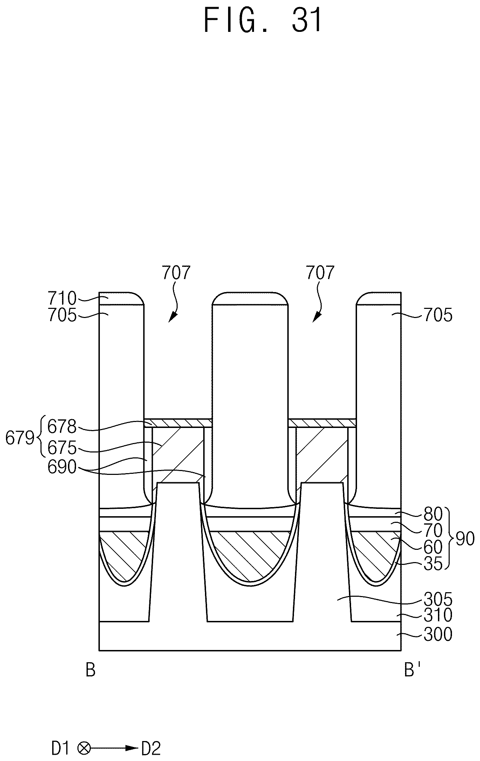

Referring to FIGS. 30 and 31, for example, a selective deposition process may be performed to form a second capping pattern 710 on the upper surfaces of the bit line structure 595, the spacer structure 660 and the fence pattern 705.

The second capping pattern 710 may be formed only on the upper surfaces of the first capping pattern 585, the spacer structure 660 and the fence pattern 705 including insulating materials, and may not be formed on the upper surface of the lower contact plug structure 679 including a conductive material.

As the etch back process for removing the upper portion of the second lower contact plug layer 677 is performed, the upper portions of the bit line structure 595, the spacer structure 660 and the fence pattern 705 may also be removed so that the upper surfaces thereof may be lowered, and the second capping pattern 710 may be formed on the bit line structure 595, the spacer structure 660 and the fence pattern 705 to compensate the lowered height of the upper surfaces thereof.

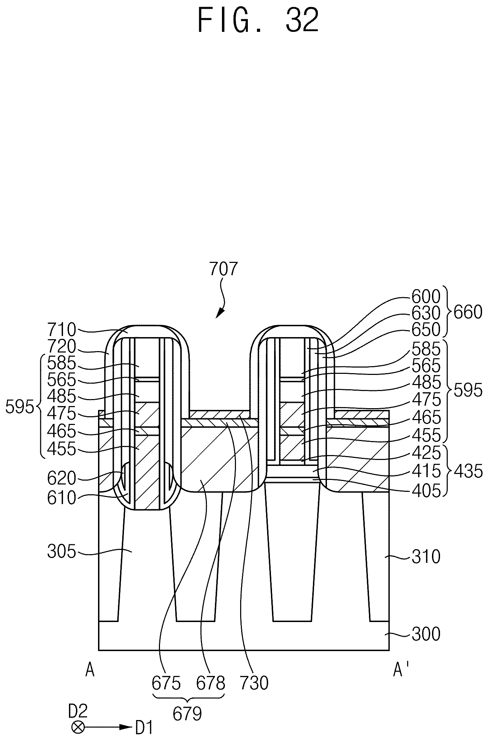

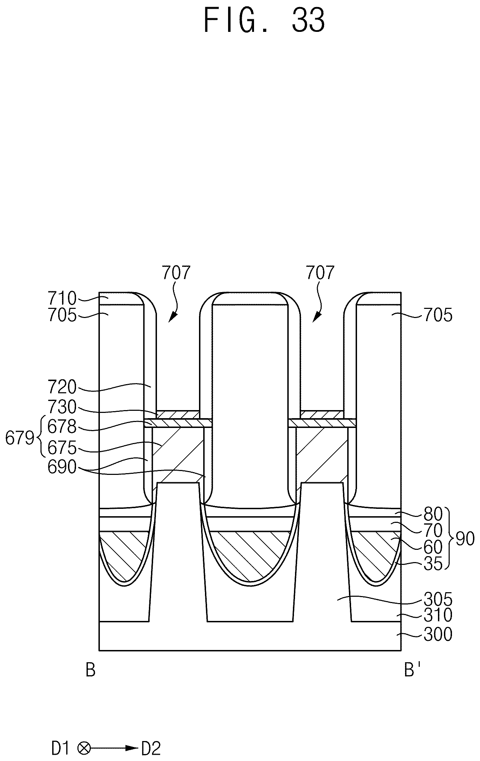

Referring to FIGS. 32 and 33, a passivation layer may be formed on an upper surface of the second capping pattern 710, a sidewall of the spacer structure 660, a sidewall of the fence pattern 705 and the upper surface of the lower contact plug structure 679, and an anisotropic etching process may be performed on the passivation layer to form a passivation pattern 720 on the sidewall in the first direction D1 of the spacer structure 660 and the sidewall in the second direction D2 of the fence pattern 705.

An ohmic contact pattern 730 may be formed on an upper surface of the second lower contact plug 678.

In example embodiments, the ohmic contact pattern 730 may be formed by forming a first metal layer on the second capping pattern 710, the passivation pattern 720 and the lower contact plug structure 679, performing a heat treatment process on the first metal layer, and removing an unreacted portion of the first metal layer.

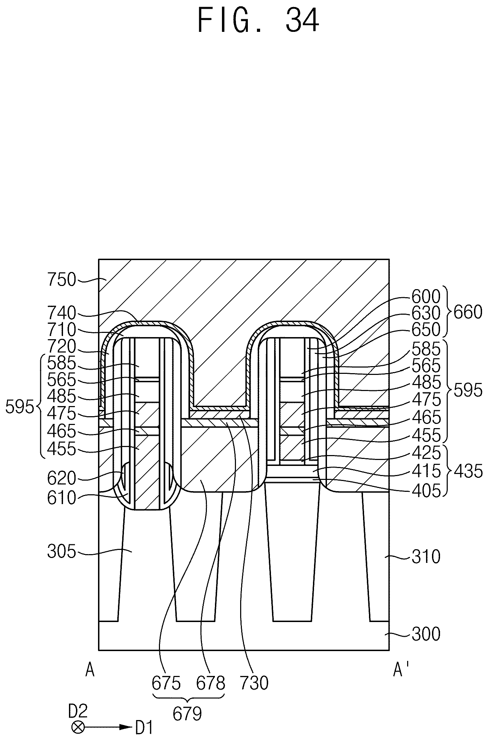

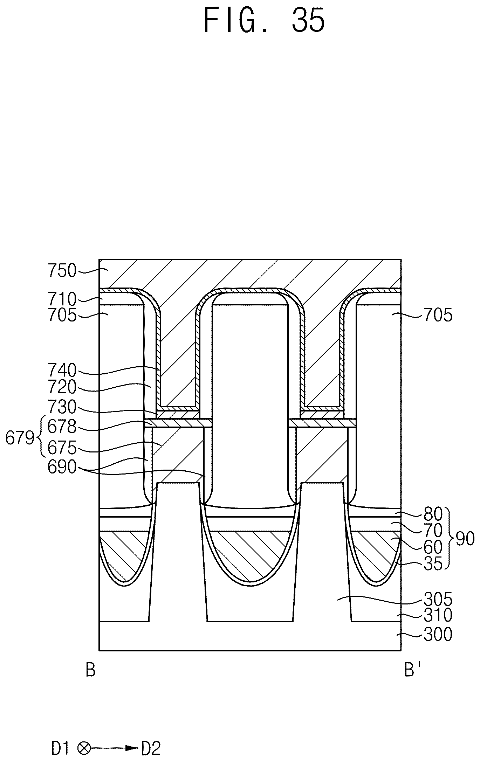

Referring to FIGS. 34 and 35, a second barrier layer 740 may be formed on the second capping pattern 710, the passivation pattern 720, the ohmic contact pattern 730, and a second metal layer 750 may be formed on the second barrier layer 740 to fill the fourth recess 707.

A planarization process may be further performed on an upper portion of the second metal layer 750. The planarization process may include a CMP process and/or an etch back process.

Referring to FIGS. 36 to 38, the second metal layer 750 and the second barrier layer 740 may be patterned to form a second metal pattern 755 and a second barrier pattern 745, respectively, which may collectively form an upper contact plug 765.

A fourth opening 760 may be formed between the upper contact plugs 765.

The fourth opening 760 may be formed by partially removing the first and second capping patterns 585 and 710, the fence pattern 705, the spacer structure 660 and the passivation pattern 720 as well as the second metal layer 750 and the second barrier layer 740.

In example embodiments, the upper contact plug 765 may have a shape of, e.g., a circle, an ellipse, a polygon, a polygon with rounded corners, etc., and may be arranged in a honeycomb pattern in the first and second directions D1 and D2, in a plan view.

The lower contact plug structure 679, the ohmic contact pattern 730 and the upper contact plug 765 sequentially stacked may collectively form a contact plug structure.

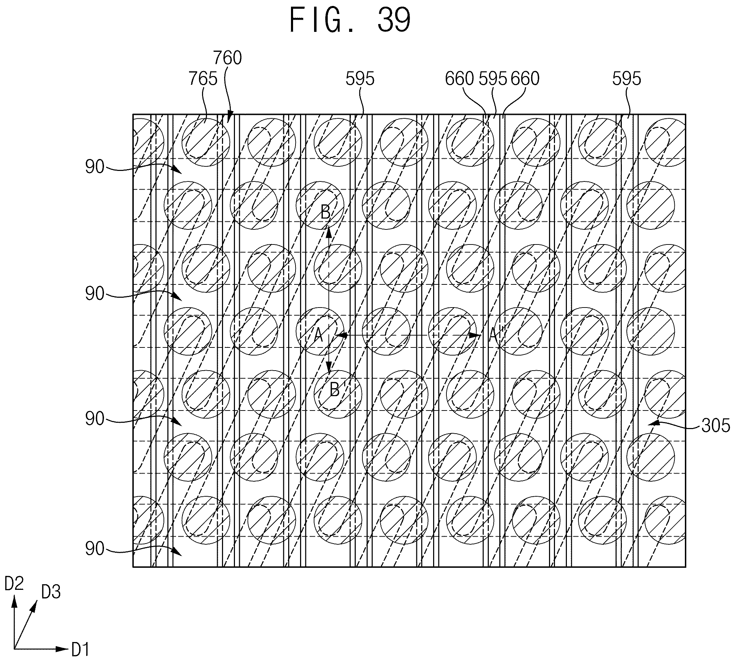

Referring to FIGS. 39 to 41, a sixth insulation pattern 770 may be formed on a bottom and a sidewall of the fourth opening 760, and a seventh insulation pattern 780 may be formed to fill a remaining portion of the fourth opening 760.

The sixth and seventh insulation patterns 770 and 780 may collectively form a second insulation pattern structure 790.

Referring to FIGS. 1 to 3 again, a second etch stop layer 800 and a mold layer may be sequentially stacked on the upper contact plug 765 and the second insulation pattern structure 790, the mold layer and the second etch stop layer 800 may be partially removed to form a fifth opening exposing an upper surface of the upper contact plug 765, and a lower electrode 810 may be formed in the fifth opening.

The mold layer may be removed, a dielectric layer 820 may be formed on a surface of the lower electrode 810, an upper electrode 830 may be formed on the dielectric layer 820 to form a capacitor 840, and a plate electrode 850 may be formed on the capacitor 840.

Upper wirings may be further formed to complete the fabrication of the semiconductor device.

As illustrated above, the first lower contact plug layer 670 extending in the first direction D1, the fourth spacers 690 may be formed on the opposite sidewalls in the second direction D2 of the first lower contact plug layer 670, the fence pattern 705 may be formed in the third opening 685 between the fourth spacers 690 on the respective sidewalls of the first lower contact plug layers 670 neighboring in the second direction D2, the upper portions of the first lower contact plug layer 670 and the fourth spacer 690 may be removed to form the first lower contact plug 675 and the third recess 676, the second lower contact plug 678 may be formed in the third recess 676 to contact the upper surfaces of the first lower contact plug 675 and the fourth spacer 690, and the ohmic contact pattern 730 may be formed on the upper surface of the second lower contact plug 678.

Thus, the planar area of the second lower contact plug 678 may be greater than the planar area of the first lower contact plug 675, and the ohmic contact pattern 730 on the upper surface of the second lower contact plug 678 may contact the lower contact plug structure 679 including the first and second lower contact plugs 675 and 678 at the increased area.

If the fourth spacers 690 are not formed on the opposite sidewalls in the second direction D2 of the first lower contact plug 675, and the second lower contact plug 678 is not formed on the first lower contact plug 675 and the fourth spacers 690, and then the ohmic contact pattern 730 is directly formed on the first lower contact plug 675, a distance or a space between the fence patterns 705 neighboring in the second direction D2 may be such small that the first metal layer for forming the ohmic contact pattern 730 may not be easily formed in the space to contact the upper surface of the first lower contact plug 675.

However, in example embodiments, the fourth spacers 690 may be formed on the opposite sidewalls in the second direction D2 of the first lower contact plug 675, the second lower contact plug 678 may be formed on the first lower contact plug 675 and the fourth spacers 690 to form the lower contact plug structure 679 having the area greater than that of the first lower contact plug 675, and the ohmic contact pattern 730 may be formed on the upper surface of the lower contact plug structure 679. Thus, even if the distance between the fence patterns 705 neighboring in the second direction D2 is small, the space between the fence patterns 705 may increase by the area of the fourth spacers 690, so that the first metal layer for forming the ohmic contact pattern 730 may be easily formed on the upper surface of the first lower contact plug 675.

As a result, the ohmic contact pattern 730 may be well formed between the lower contact plug structure 679 and the upper contact plug 765, and a contact resistance between the lower contact plug structure 679 and the upper contact plug 765 may be effectively reduced by the ohmic contact pattern 730, so that the semiconductor device including the lower contact plug structure 679, the ohmic contact pattern 730 and the upper contact plug 765 may have enhanced electric characteristics.

The second lower contact plug layer 677 may be formed on the first lower contact plug 675, and an etch back process may be performed on the second lower contact plug layer 677 to form the lower contact plug structure 679. Thus, during the etch back process, the upper portions of the bit line structure 595, the spacer structure 660 and the fence pattern 705 may also be removed so that the upper surfaces thereof may be lowered. However, the second capping pattern 710 may be formed on the upper surfaces of the bit line structure 595, the spacer structure 660 and the fence pattern 705 by a SEG process, so that the reduced heights of the upper surfaces of the bit line structure 595, the spacer structure 660 and the fence pattern 705 may be compensated.

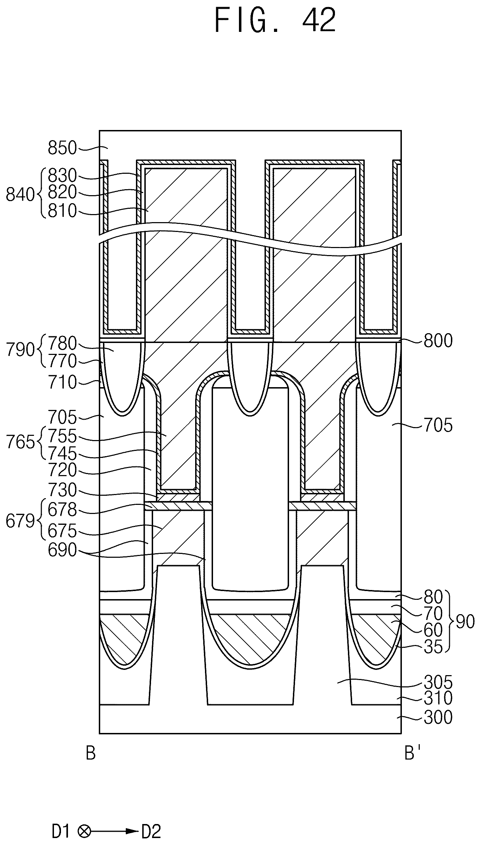

FIG. 42 is a cross-sectional view illustrating a semiconductor device in accordance with example embodiments, which may correspond to FIG. 3.

This semiconductor device may be substantially the same as or similar to that of FIGS. 1 to 3, except for the shape of the fourth spacer, and thus repeated explanations are omitted herein.

Referring to FIG. 42, the fourth spacer 690 may cover not only the lower portion of the sidewall in the second direction D2 of the fence pattern 705 but also a lower surface of the fence pattern 705.

After forming the fourth spacer layer by the process illustrated with reference to FIG. 18, the anisotropic etching process may not be performed on the fourth spacer layer, so that the fourth spacer layer may also remain on the sidewall and the upper surface of the sacrificial mask 672, and the upper surfaces of the active pattern 305, the isolation pattern 310, the gate mask 80 and the gate insulation pattern 35 exposed by the third opening 685.

Accordingly, the fourth spacer 690 may contact the upper surfaces of the active pattern 305, the isolation pattern 310, the gate mask 80 and the gate insulation pattern 35.

In the method of manufacturing a semiconductor device in accordance with example embodiments, an active pattern may be formed on a substrate. A gate structure may be formed in an upper portion of the active pattern. A bit line structure may be formed on a central portion of the active pattern. A first lower contact plug layer may be formed on each of opposite end portions of the active pattern. Spacers may be formed on opposite sidewalls, respectively, of the first lower contact plug layer. Fence patterns contacting the spacers, respectively, may be formed. An upper portion of the first lower contact plug layer may be removed to form at least one first lower contact plug. A second lower contact plug may be formed on an upper surface of the at least one first lower contact plug and upper surfaces of the spacers. An ohmic contact pattern may be formed on the second lower contact plug. An upper contact plug may be formed on the ohmic contact pattern. A capacitor may be formed on the contact plug structure.

In example embodiments, when removing the upper portion of the first lower contact plug layer to form the at least one first lower contact plug, upper portions of the spacers may be removed such that the upper surfaces of the spacers may be substantially coplanar with the upper surface of the at least one first lower contact plug.

In example embodiments, the bit line structure may extend in a first direction substantially parallel to an upper surface of the substrate, and the first lower contact plug layer may be formed on the substrate and the bit line structure to extend in a second direction substantially parallel to the upper surface of the substrate and crossing the first direction. When the upper portion of the first lower contact plug layer is removed to form the at least one first lower contact plug, a plurality of first lower contact plugs spaced apart from each other in the second direction may be formed.

In example embodiments, the spacers may be formed on opposite sidewalls, respectively, of each of the plurality of first lower contact plugs.

In example embodiments, when the fence patterns contacting the spacers, respectively, are formed, a fence layer extending in the first direction may be formed on the substrate, the first lower contact plug layer and the spacers. An upper portion of the fence layer may be removed so that the fence layer may be divided into a plurality of fence patterns spaced apart from each other in the first direction.

In example embodiments, when the first lower contact plug layer is formed on each of opposite end portions of the active pattern, a first deposition process may be performed to form the first lower contact plug layer. A first melting laser annealing (MLA) process may be performed on the first lower contact plug layer.

In example embodiments, when the second lower contact plug is formed on the upper surface of the at least one first lower contact plug and upper surfaces of the spacers, a second deposition process may be performed to form the second lower contact plug. A second melting laser annealing (MLA) process may be performed on the second lower contact plug.

In example embodiments, when the second lower contact plug is formed on the upper surface of the at least one first lower contact plug and upper surfaces of the spacers, a selective epitaxial growth (SEG) process may be performed using an upper surface of the at least one first lower contact plug as a seed.

In example embodiments, after forming the second lower contact plug, a selective epitaxial growth (SEG) process may be performed to form a capping pattern on an upper surface of the bit line structure and upper surfaces of the fence patterns.

In example embodiments, before forming the ohmic contact pattern on the second lower contact plug, a passivation pattern may be formed on a sidewall of the bit line structure and sidewalls of the fence patterns. The ohmic contact pattern may contact a sidewall of the passivation pattern.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
an active pattern on a substrate;
a gate structure in an upper portion of the active pattern;
a bit line structure on a central portion of the active pattern;
a contact plug structure on each of opposite end portions of the active pattern, the contact plug structure including:
a first lower contact plug;
a second lower contact plug on the first lower contact plug, the second lower contact plug having a width greater than a width of the first lower contact plug in a vertical cross-section of the semiconductor device;
an ohmic contact pattern on the second lower contact plug; and
an upper contact plug on the ohmic contact pattern;
spacers on opposite sidewalls, respectively, of the first lower contact plug, each of the spacers having a lowermost surface lower than or substantially coplanar with a lowermost surface of the first lower contact plug; and
a capacitor on the contact plug structure.

2. The semiconductor device according to claim 1, wherein each of the spacers does not overlap the first lower contact plug in a vertical direction substantially perpendicular to an upper surface of the substrate.

3. The semiconductor device according to claim 1, wherein the second lower contact plug contacts an upper surface of the first lower contact plug and upper surfaces of the spacers.

4. The semiconductor device according to claim 1, wherein the width of the second lower contact plug is substantially equal to a sum of the width of the first lower contact plug and widths of the spacers in the cross-section of the semiconductor device.

5. The semiconductor device according to claim 1, wherein the bit line structure extends in a first direction substantially parallel to an upper surface of the substrate, and
wherein a width in the first direction of the second lower contact plug is greater than a width in the first direction of the first lower contact plug.

6. The semiconductor device according to claim 5, wherein the spacers are disposed on opposite sidewalls, respectively, in the first direction of the first lower contact plug.

7. The semiconductor device according to claim 6, further comprising fence patterns on the substrate, the fence patterns contacting sidewalls, respectively, in the first direction of the spacers.

8. The semiconductor device according to claim 7, wherein opposite sidewalls in the first direction of the second lower contact plug contact the fence patterns, respectively.

9. The semiconductor device according to claim 7, further comprising a passivation pattern contacting an upper portion of a sidewall in the first direction of each of the fence patterns and a sidewall in the first direction of the ohmic contact pattern.

10. The semiconductor device according to claim 9, wherein at least a portion of the passivation pattern overlaps a corresponding one of the spacers in a vertical direction substrate perpendicular to the upper surface of the substrate.

11. The semiconductor device according to claim 7, further comprising a capping pattern on an upper surface of the bit line structure and an upper surface of each of the fence patterns.

12. The semiconductor device according to claim 1, further comprising a spacer structure on a sidewall of the bit line structure,
wherein the spacer structure contacts the first and second lower contact plugs.

13. A semiconductor device comprising:
an active pattern on a substrate;
a gate structure in an upper portion of the active pattern;
a bit line structure on a central portion of the active pattern;
a first lower contact plug on each of opposite end portions of the active pattern;
spacers on opposite sidewalls, respectively, of the first lower contact plug, each of the spacers not overlapping the first lower contact plug in a vertical direction substantially perpendicular to an upper surface of the substrate;
a second lower contact plug contacting an upper surface of the first lower contact plug and upper surfaces of the spacers;
an ohmic contact pattern on the second lower contact plug;
an upper contact plug on the ohmic contact pattern; and
a capacitor on the upper contact plug.

14. The semiconductor device according to claim 13, wherein a width of the second lower contact plug is substantially equal to a sum of a width of the first lower contact plug and widths of the spacers in a vertical cross-section of the semiconductor device.

15. The semiconductor device according to claim 13, wherein the bit line structure extends in a first direction substantially parallel to an upper surface of the substrate, and
wherein a width in the first direction of the second lower contact plug is greater than a width in the first direction of the first lower contact plug in a vertical cross-section of the semiconductor device.
